# EUROPÄISCHE PATENTSCHRIFT

(11) **EP 3 681 754 B1**
(45) Veröffentlichungstag und Bekanntmachung des Hinweises auf die Patenterteilung: **14.09.2022**
(21) Anmeldenummer: 18739840.9
(22) Anmeldetag: 10.07.2018
(51) Int. Cl.: B60L 53/30

(54) **VERFAHREN ZUM ERFASSEN VON VERLÄUFEN VON LADESTRÖMEN**
METHOD FOR DETECTING PROFILES OF CHARGING CURRENTS
PROCÉDÉ POUR DÉTECTER DES VARIATIONS DE COURANTS DE CHARGE

(30) Priorität: 12.09.2017 DE 102017121034
(43) Veröffentlichungstag der Anmeldung: 22.07.2020
(73) Patentinhaber: Compleo Charging Solutions AG, 44309 Dortmund (DE)
(72) Erfinder: SKRBIC, Srdan, 44265 Dortmund (DE); WAFFNER, Jürgen, 45307 Essen (DE)
(74) Vertreter: Gottschald Patentanwälte Partnerschaft mbB
(86) Internationale Anmeldenummer: PCT/EP2018/068673
(87) Internationale Veröffentlichungsnummer: WO 2019/052710

(56) Entgegenhaltungen:
- JP-A- 2013 110 877
- US-A1- 2012 166 011
- US-A1- 2017 170 871

## Beschreibung

Der Gegenstand betrifft ein Verfahren zum Erfassen von Verläufen von Ladeströmen für Elektrofahrzeuge an Ladestationen.

In Ladestationen werden Messgeräte, sogenannte Smartmeter verbaut, die den Ladestrom und somit die von dem ladenden Fahrzeug bezogene elektrische Energie messen. Aus den Messwerten der Smartmeter werden in den Ladestationen oder in einem Zentralrechner (Backend) die dem Kunden in Rechnung zu stellenden Kosten zumindest in Teilen berechnet.

Für eine zentrale Verarbeitung der Ladeinformationen, insbesondere den Informationen zu dem Ladestrom als auch zu der bezogenen Energie sind die Ladestationen, respektive deren Smartmeter, über ein Weitverkehrsnetz mit einem Zentralrechner verbunden. Innerhalb der Ladestation sind die Smartmeter insbesondere über ein Bussystem mit dem Controller der Ladestation verbunden.

In der Regel wird eine nicht mehr reagierende Ladestation bzw. ein nicht mehr reagierendes Smartmeter als defekt eingestuft und ein Servicetechniker kann vor Ort die Ladestation und das Messgerät begutachten und gegebenenfalls den Fehler beheben.

Problematisch sind jedoch solche Messgeräte, die zwar einen Ladestrom und somit eine Energie messen, diese Messung jedoch fehlerhaft ist. Diese Ladestationen melden nach wie vor abrechnungsrelevante Daten an das Backend. Dort ist aber nicht erkennbar, ob die Daten auf einer korrekten oder einer fehlerhaften Messung basieren. Somit ist es bisher nahezu unmöglich, aus empfangenen Messwerten unmittelbar zu schließen, dass ein Messgerät in einer Ladestation defekt ist.

Die JP2013110877A offenbart ein Ladesystem und ein Parksystem, die einfach zu installieren sind, eine hohe Erweitbarkeit aufweisen und für jedes geparkte Fahrzeug eine einfache Steuerung ermöglichen.

Dem Gegenstand lag die Aufgabe zugrunde, fehlerhafte Messgeräte in einer Ladestation detektieren zu können.

Durch den massenhaften Einsatz von Ladestationen, welche räumlich weit verteilt sind, ist eine flächendeckende, fortwährende Vor-Ort Diagnose von Ladestationen und deren Messtechnik unmöglich. Es muss jedoch sichergestellt sein, dass die Messergebnisse korrekt sind und den Kunden korrekte Energiemengen in Rechnung gestellt werden.

Die Erfinder haben erkannt, dass fehlerhafte Messgeräte dadurch detektiert werden können, dass deren aufgezeichneten Ladekurven von Ladekurven anderer Ladestationen abweichen. Darüber hinaus haben die Erfinder erkannt, dass eine solche Abweichung auch in dem Fahrzeugtyp bzw. dem jeweiligen Fahrzeug liegen kann und somit eine fehlerhafte Messtechnik in einer Ladestation nur unter Berücksichtigung der Fahrzeugkennung detektierbar ist.

Es wird nun vorgeschlagen, zunächst einen Verlauf eines Ladestroms einer Ladestation zu erfassen. Ein Verlauf eines Ladestroms kann auch als Ladekurve verstanden werden.

Darüber hinaus wird vorgeschlagen, dass der erfasste Verlauf des Ladestroms zusammen mit einer Fahrzeugkennung des ladenden Fahrzeugs gespeichert wird. Somit liegen in einem Speicher zu jeweils einem Ladevorgang ein Verlauf des Ladestroms und eine entsprechende Fahrzeugkennung vor. Damit ist es möglich, für ein und dasselbe Fahrzeug verschiedene Verläufe von Ladeströmen auszuwerten. Eine solche Auswertung kann auch über eine Vielzahl von Ladestationen erfolgen, da insbesondere das Speichern und das nachfolgende Auswerten der Ladekurven in einem zentralseitigen Rechner durchgeführt werden kann.

Es wird vorgeschlagen, dass für jeweils eine Fahrzeugkennung ein Verlauf des Ladestroms an einer Mehrzahl an Ladestationen gespeichert wird. Ein Fahrzeug, welches sich im Feld bewegt, lädt in der Regel an verschiedenen Ladestationen. Jeder dieser Ladevorgänge kann dem Fahrzeug anhand der Fahrzeugkennung eindeutig zugeordnet werden. Somit können eine Mehrzahl an Ladekurven eines einzigen Fahrzeugs in dem zentralseitigen Rechner empfangen und gespeichert werden.

Lädt nun ein Fahrzeug an einer Ladestation, so wird ein aktueller Verlauf des Ladestroms erfasst und gespeichert. Dieser aktuelle Verlauf des Ladestroms kann anschließend mit gespeicherten Verläufen des Ladestroms dieses jeweiligen Fahrzeugs an der Mehrzahl an Ladestationen verglichen werden. Das heißt, wenn ein Fahrzeug an einer Ladestation lädt, kann dieser Ladevorgang mit anderen Ladevorgängen dieses Fahrzeugs an anderen Ladestationen verglichen werden. Durch den Vergleich von Ladevorgängen ein und desselben Fahrzeugs kann ausgeschlossen werden, dass Unterschiede in den Ladeverläufen durch unterschiedliche Fahrzeuge verursacht werden.

Mit Hilfe des Vergleichs eines aktuellen Verlaufs des Ladestroms mit gespeicherten Verläufen des Ladestroms an einer Mehrzahl an Ladestationen für eine jeweilige Fahrzeugkennung wird erkannt, ob sich eine Ladestation auffällig gegenüber anderen Ladestationen verhält.

Hierzu wird vorgeschlagen, dass bei einer Abweichung des aktuellen Verlaufs des Ladestroms von den gespeicherten Verläufen des Ladestroms an der Mehrzahl an Ladestationen, die größer ist, als ein Grenzwert, ein Signal ausgegeben wird.

Durch geeignete Vergleiche der Verläufe der Ladeströme, insbesondere durch geeignete Vergleiche der Ladekurven ist es möglich, festzustellen, ob eine aktuelle Ladekurve von bisherigen Ladekurven signifikant abweicht, also eine Abweichung größer als ein Grenzwert ist. In diesem Fall kann ein Signal ausgegeben werden.

Es wird vorgeschlagen, dass für eine Mehrzahl an Ladestationen jeweils Verläufe von Ladeströmen zusammen mit einer Fahrzeugkennung des ladenden Fahrzeugs gespeichert werden. Diese Speicherung erfolgt vorzugsweise in einem zentralen Backend, welches über ein Weitverkehrsnetz mit den jeweiligen Ladestationen verbunden ist. Unter Verwendung der Fahrzeugkennung können dann alle Ladevorgänge eines einzelnen Fahrzeugs an verschiedenen Ladestationen ermittelt und ausgewertet werden. Dies ist insbesondere von Interesse, um festzustellen, ob ein Ladeverlauf an einer Ladestation bei einem bestimmten Fahrzeug von Ladeverläufen an anderen Ladestationen durch dieses Fahrzeug abweicht. Dies kann ein Indiz dafür sein, dass die Ladestation, an der der aktuelle Ladevorgang läuft bzw. gerade abgeschlossen ist, fehlerhaft ist.

Es kann jedoch auch sein, dass zwischen zwei Ladevorgängen ein Fahrzeug defekt geworden ist. Ein solcher Ladevorgang würde unter alleiniger Verwendung der bisherigen Ladevorgänge dieses Fahrzeugs an anderen Ladestationen als fehlerhaft qualifiziert und die Ladestation würde vor Ort gewartet werden.

Um einen solchen Fall auszuschließen, wird vorgeschlagen, dass für jeweils eine von einer Mehrzahl an Ladestationen die Verläufe des Ladestroms für eine Mehrzahl von Fahrzeugkennung gespeichert werden. Das heißt, dass für jede einzelne Ladestation die Ladekurven auch für eine Mehrzahl von Fahrzeugen gespeichert werden. Hierzu kann es beispielsweise sinnvoll sein, zusammen mit dem Verlauf des Ladestroms und der Fahrzeugkennung auch eine Ladestationskennung abzuspeichern. Dann kann in dem zentralen Rechner unter Verwendung entweder der Fahrzeugkennung oder der Ladestationskennung jeweils nach Verläufen von Ladeströmen gefiltert werden, die einem einzelnen Fahrzeug oder einer einzelnen Ladestation zuzuordnen sind.

Anschließend kann ein aktueller Verlauf des Ladestroms mit gespeicherten Verläufen des Ladestroms an der jeweiligen Ladestation verglichen werden. Bei diesem Vergleich wird nicht der Verlauf des Ladestroms an einer Ladestation mit Verläufen des Ladestroms an anderen Ladestationen verglichen, sondern es wird verglichen, wie sich der aktuelle Ladevorgang im Verhältnis zu bisherigen Ladevorgängen an dieser jeweiligen Ladestation verhält.

Auch wird vorgeschlagen, dass bei einer Abweichung des aktuellen Verlaufs des Ladestroms von den gespeicherten Verläufen des Ladestroms an der jeweiligen Ladestation die um einen Grenzwert abweicht, ein Signal ausgegeben wird.

Gemäß einem weiteren Ausführungsbeispiel wird vorgeschlagen, dass zunächst die Abweichung des aktuellen Verlaufs des Ladestroms von den gespeicherten Verläufen des Ladestroms an der Mehrzahl an Ladestationen ausgewertet wird und wenn ein Signal ausgegeben wird, anschließend die Abweichung des aktuellen Verlauf des Ladestroms mit gespeicherten Verläufen des Ladestroms an der jeweiligen Ladestation, insbesondere für unterschiedliche Fahrzeugkennungen, bestimmt wird. Bei einer Abweichung um einen Grenzwert kann ein Fehlersignal ausgegeben werden.

Gemäß der Erfindung wird vorgeschlagen, dass für jeweils eine Fahrzeugkennung aus den gespeicherten Verläufen von Ladeströmen an verschiedenen Ladestationen ein das Fahrzeug charakterisierender Verlauf des Ladestroms errechnet wird. Bewegt sich das Fahrzeug im Feld und lädt an verschiedenen Ladestationen, so verhält sich das Fahrzeug an diese Ladestationen stets gleich, vorausgesetzt, es ist nicht defekt. Dieses Verhalten kann als ein das Fahrzeug charakterisierender Verlauf des Ladestroms bezeichnet werden. Der das Fahrzeug charakterisierender Verlauf kann aus einer bestimmten Anzahl vorhergehender Verläufen bestimmt werden. Es kann ein gleitendes Fenster über die Anzahl der Verläufe verwendet werden. Die Anzahl kann z.B. zwischen 10, 20, 30 oder 50 und 100, 200, 500 oder 1000 sein.

Auch wird vorgeschlagen, dass das Signal ausgegeben wird, wenn eine Abweichung des aktuellen Verlaufs des Ladestroms von dem das Fahrzeug charakterisierenden Verlauf des Ladestroms über einem Grenzwert liegt.

Gemäß einem Ausführungsbeispiel wird vorgeschlagen, dass für jeweils eine Ladestation aus den gespeicherten Verläufen von Ladeströmen mit verschiedenen Fahrzeugkennungen ein die Ladestation charakterisierender Verlauf des Ladestroms errechnet wird. Auch verhält sich die Ladestation charakteristisch bei unterschiedlichen Ladevorgängen mit unterschiedlichen Fahrzeugen. Dies kann als ein die Ladestation charakterisierender Verlauf des Ladestroms bezeichnet werden. Der die Ladestation charakterisierender Verlauf kann aus einer bestimmten Anzahl vorhergehenden Verläufen bestimmt werden. Es kann ein gleitendes Fenster über die Anzahl der Verläufe verwendet werden. Die Anzahl kann z.B. zwischen 10, 20, 30 oder 50 und 100, 200, 500 oder 1000 sein.

Gemäß der Erfindung wird vorgeschlagen, dass der das Fahrzeug charakterisierende Verlauf des Ladestroms als gemittelter Wert der gespeicherten Verläufe von Ladeströmen für die Fahrzeugkennung errechnet wird.

Gemäß einem weiteren Ausführungsbeispiel wird vorgeschlagen, dass der die Ladestation charakterisierende Verlauf des Ladestroms als gemittelter Wert der gespeicherten Verläufe von Ladeströmen für die Ladestation errechnet wird. Ein Verlauf des Ladestroms kann aus diskreten Werten (Stützpunkte) gebildet sein, die beispielsweise in Minutenabschnitten, 5-Minutenabschnitten, 15-Minutenabschnitten, ausgehend vom Beginn oder vom Ende der Ladung bestimmt werden. Auch ist es möglich, dass wenn der Ladestrom einen unteren Grenzwert erreicht, also die Ladung beendet ist, von diesem Zeitpunkt aus rückwärtig in den genannten Zeitintervallen die jeweiligen diskreten Werte bestimmt werden. Somit kann eine Reihe von Messwerten mit insbesondere äquidistanten Zeitabständen gebildet werden.

Bei einem Vergleich der Verläufe der Ladeströme kann beispielsweise zunächst festgestellt werden, an welchen Stützpunkten (Messpunkten) die Ladeströme gleich sind. Ausgehend von diesen Stützpunkten kann vorwärts und/oder rückwärts ein Vergleich der weiteren Stützpunkte durchgeführt werden und beispielsweise eine Abweichung der Beträge der Ladeströme berechnet werden. Insbesondere ist es möglich, die Ladekurve charakterisierende Punkte miteinander zu vergleichen. Bei vergleichbaren Rahmenbedingungen sind die Ladekurve verschiedener Fahrzeuge in vergleichbaren Abschnitten gleich. So kann z.B. je nach verwendeter Ladetechnik die Ladekurve verschieden verlaufen. Ein beispielhafter Verlauf kann sein:
leerer Akku -> Start mit 60% der maximalen Ladeleistung;
Erhöhung auf 100% der maximalen Ladeleistung nach 5 Minuten;
langsames Verringern Ladeleistung nach 35 min, bis sie nach 50 min bei unter 5% sind. Die Punkte, an denen die Leistung verändert wird sowie die jeweiligen Zeitabstände dazwischen können z.B. solche charakterisierende Punkte sein.

Auch können solche Ladevorgänge vom Vergleich ausgeschlossen werden, bei denen keine maximale Ladung entnommen wird, wenn z.B. ein Fahrzeug nahezu vollständig geladen wird, wenn es den Ladevorgang beginnt. Dann kann die Gesamtladekurve / Dauer, bis die Ladeströme unter 5% so kurz sein, so dass diese Ladung nur wenig vergleichbare Daten liefert

Gemäß einem Ausführungsbeispiel wird vorgeschlagen, dass für jeweils eine Ladestation die Verläufe von Ladeströmen mit verschiedenen Fahrzeugkennungen mit einem aktuellen Verlauf eines Ladestroms für eine Fahrzeugkennung abhängig von dem Signal verglichen werden. Das heißt, dass zunächst die Abweichung des Verlaufs an der Ladestation für die jeweilige Fahrzeugkennung von Verläufen von Ladeströmen an anderen Ladestationen dieser Fahrzeugkennung festgestellt wird um anschließend den Verlauf mit bisherigen Ladestromverläufen an der jeweiligen Ladestation zu vergleichen.

Neben dem Fahrzeugtyp spielt natürlich auch beispielsweise die Umgebungstemperatur, die Temperatur innerhalb der Ladestation, die Batterietemperatur oder dergleichen eine Rolle. Aus diesem Grunde wird vorgeschlagen, dass zusammen mit dem Verlauf des Ladestroms eine Temperatur gespeichert wird. Die gespeicherte Temperatur kann zumindest eine der oben genannten Temperaturen sein. Anschließend ist es möglich, die jeweils erfassten und gespeicherten Verläufe von Ladeströmen jeweils einem Temperaturbereich zuzuordnen. So ist es möglich, mehrere Temperaturbereiche, beispielsweise in jeweils 5°C-Abständen zu bilden. Für jedes dieser Intervalle werden die entsprechenden Verläufe von Ladeströmen gesammelt und ein aktueller Verlauf des Ladestroms wird mit solchen Verläufen von Ladeströmen verglichen, die dem Temperaturbereich zugeordnet sind, der der entsprechenden aktuellen Temperatur entspricht.

Dasselbe gilt natürlich auch für die Kabelgarnitur, insbesondere die Art des Kabels, die Art des Steckers und dergleichen. Liegen Informationen zur Kabelgarnitur vor, so können diese Informationen ebenfalls abgespeichert werden. Anschließend können die erfassten und gespeicherten Verläufe der Ladeströme den entsprechenden Typen von Kabelgarnituren zugeordnet werden. Somit wird jeweils für eine Kabelgarnitur ein Satz von Verläufen von Ladeströmen erfasst. Ein aktueller Verlauf eines Ladestroms kann dann mit denjenigen gespeicherten Verläufen von Ladeströmen verglichen werden, die der aktuellen Kabelgarnitur zugeordnet sind.

Nachfolgend wird der Gegenstand anhand einer Ausführungsbeispiele zeigenden Zeichnung näher erläutert. In der Zeichnung zeigen:
- Fig. 1: einen schematischen Aufbau eines Systems zur Durchführung des gegenständlichen Verfahrens;
- Fig. 2a-d: verschiedene Verläufe von Ladeströmen an verschiedenen Ladestationen für jeweils eine Fahrzeugkennung;
- Fig. 3a-d: verschiedene Verläufe von Ladeströmen an einer Ladestation durch verschiedene Fahrzeuge;
- Fig. 4a,b: Vergleiche von aktuellen Verläufen von Ladeströmen mit einem das Fahrzeug charakterisierenden Ladestrom;
- Fig. 5a,b: Vergleich eines aktuellen Verlaufs eines Ladestroms mit die Ladestation charakterisierenden Verläufen von Ladeströmen.

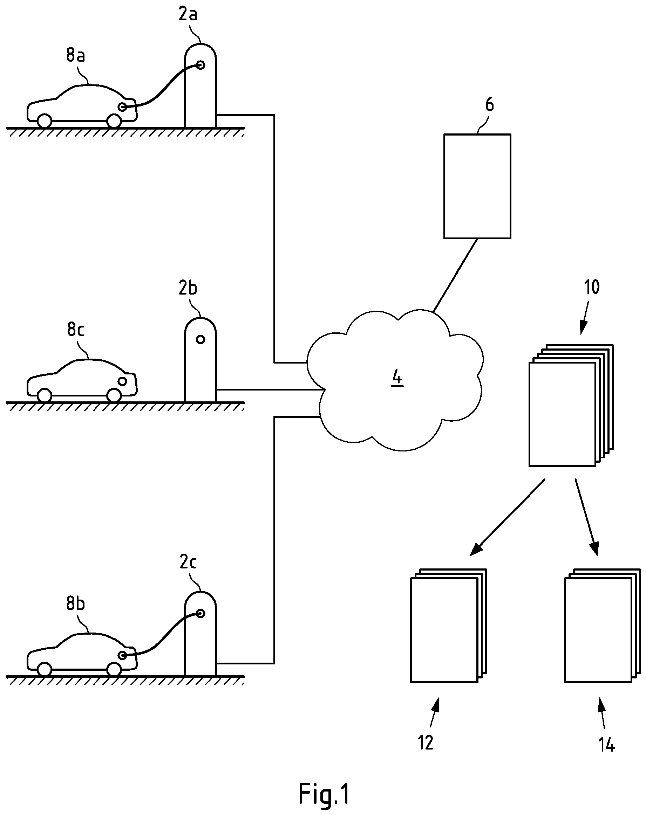

Fig. 1 zeigt ein System mit Ladestationen 2a-c, einem Weitverkehrsnetz 4, einem zentralen Backend 6 sowie drei Fahrzeugen 8a, b, c.

Lädt eines der Fahrzeuge 8a, b, c an einer der Ladestationen 2a-c, so misst die Ladestation 2a-c fortwährend den Ladestrom und erfasst die bezogene Energiemenge. Sowohl der Verlauf des Ladestroms als auch die Energiemenge, die in einer der Ladestationen 2a-c erfasst werden, werden über das Weitverkehrsnetz 4 an das Backend 6 übermittelt. Zusammen mit dieser Übermittlung wird zumindest eine Information zu einer Fahrzeugkennung als auch eine Fahrzeuginformation zu einer Ladestationskennung übermittelt.

In den Fahrzeugen 8a, b, c ist jeweils eine Kennung hinterlegt, die der Ladestation 2a-c zu Beginn, während und/oder zum Ende eines Ladevorgangs mitgeteilt wird. Dadurch ist der Ladevorgang eindeutig einem der Fahrzeuge 8a, b, c zuzuordnen. Die Fahrzeugkennungen der Fahrzeuge 8a, b, c sind voneinander unterschiedlich und insbesondere sind die Fahrzeugkennungen eindeutig.

Das Gleiche gilt für die Ladestationskennungen. Jede Ladestation 2a-c kann eine eindeutige Kennung aufweisen, welche die Ladestation 2a-c von den jeweils anderen Ladestationen 2a-c unterscheidet.

Die Verläufe der Ladeströme werden insbesondere als Reihen von Messwerten mit äquidistanten Zeitabschnitten übermittelt.

In dem Backend 6 liegt somit ein Satz 10 von Verläufen von Ladeströmen vor. Unter Verwendung einerseits der Fahrzeugkennung ist es möglich, aus diesem Satz 10 einen Satz 12 zu filtern, der jeweils einem bestimmten Fahrzeug zuzuordnen ist. Unter Verwendung einer Ladestationskennung ist es möglich, aus dem Satz 10 einen Satz 14 zu filtern, welcher die Verläufe der Ladeströme enthält, die von einer bestimmten Ladestation stammen.

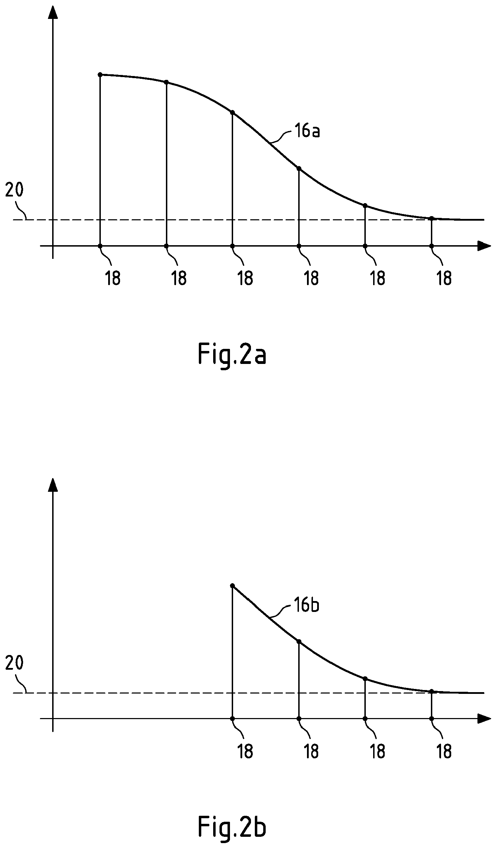

Die Figuren 2a-c zeigen beispielsweise Verläufe von Ladeströmen aus dem Satz 12.

So zeigt Fig. 2a beispielsweise einen ersten Verlauf 16a eines Ladestroms eines Fahrzeugs 8a. Dieser Verlauf 16a kann beispielsweise an der Ladestation 2a erfasst werden. Zu erkennen ist, dass der Verlauf 16a als Reihe äquidistanter, diskreter Werte 18 aufgezeichnet werden kann.

Auch ist beispielhaft in der Fig. 2a zu erkennen, dass beispielsweise wenn ein unterer Grenzwert 20 erreicht ist, hiervon ausgehend die diskreten Werte 18 in gleichen Zeitabständen bestimmt werden. Die diskreten Werte 18 werden über das Weitverkehrsnetz 4 von der Ladestation 2a an das Backend 16 übermittelt.

Fig. 2b zeigt einen Ladevorgang, den das Fahrzeug 8a beispielsweise an der Ladestation 2b durchgeführt hat. Dies kann der Verlauf 16b sein. Auch hier ist zu erkennen, dass dieser Verlauf 16b durch diskrete Werte 18 abgebildet werden kann, die äquidistant zueinander sind. In dem Verlauf 16b gemäß der Fig. 2b ist zu erkennen, dass der Ladevorgang kürzer war und insbesondere bei einer geringeren Stromstärke begonnen hat. Dies kann beispielsweise darin begründet liegen, dass das Fahrzeug 8a zu Beginn des Ladevorgangs an der Ladestation 2b bereits teilweise geladen war.

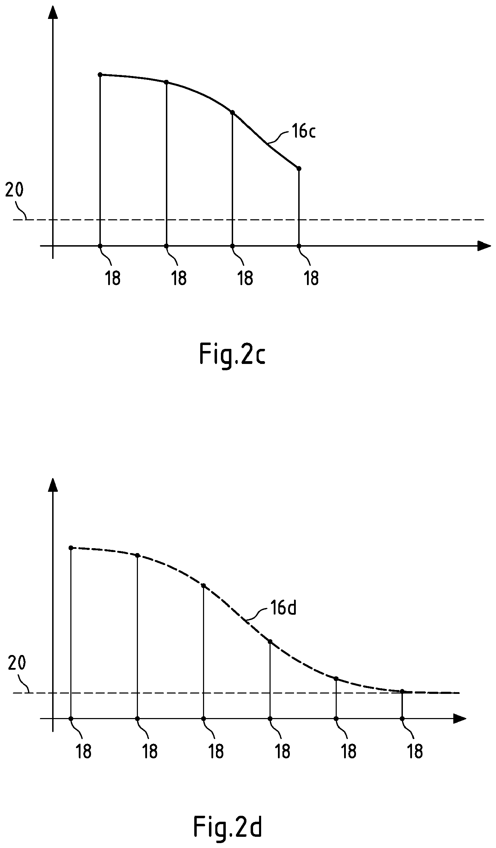

Schließlich zeigt Fig. 2c einen Verlauf 16c eines Ladevorgangs des Fahrzeugs 8a an der Ladestation 2c. Auch hier ist zu erkennen, dass äquidistante diskrete Werte 18 aus dem Verlauf 16c ermittelt werden. Bei diesem Verlauf 16c wurde das Fahrzeug beispielsweise mit einer nahezu leeren Batterie an die Ladestation 2c angeschlossen, jedoch vor Beendigung des Ladevorgangs abgetrennt.

Fig. 2d zeigt einen das Fahrzeug charakterisierenden Verlauf 16d des Ladestroms. Dieser kann durch eine Interpolation der in dem Satz 12 hinterlegten Verläufe 16a-c bestimmt werden. Auch dieser Verlauf 16d kann aus diskreten Werte 18 als Reihe gebildet werden. Unter Verwendung aller oder einer Vielzahl von in dem Satz 12 für beispielsweise das Fahrzeug 8a hinterlegten Verläufe 16a-c kann der das Fahrzeug charakterisierende Verlauf 16d berechnet werden.

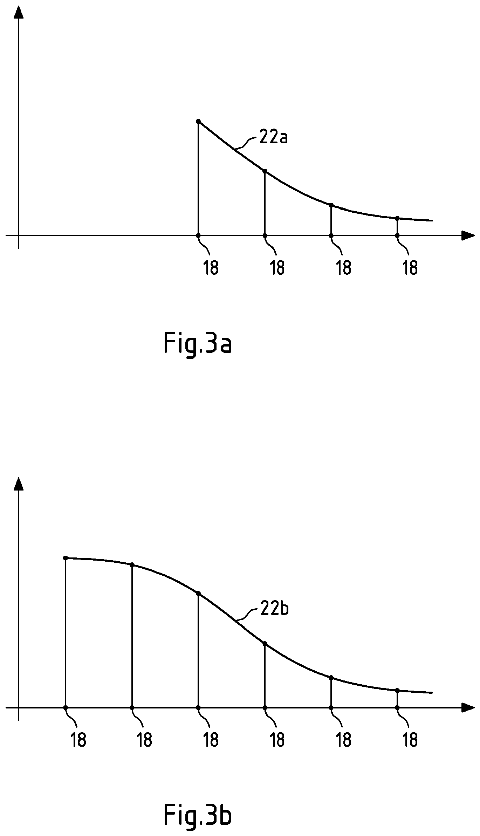

Auch ist es möglich, dass verschiedene Fahrzeuge 8a-c an ein und derselben Ladestation 2a laden. Dies ist beispielhaft in den Figuren 3a-c dargestellt.

Die Figuren 3a-c zeigen beispielsweise Verläufe von Ladeströmen aus dem Satz 14.

Die Fig. 3a zeigt einen Verlauf 22a eines Ladevorgangs des Fahrzeugs 8a an der Ladestation 2a. Auch hier sind wiederum diskrete Werte 18 äquidistant zueinander erfasst. Der Verlauf 22a kann in dem Backend 6 in dem Satz 10 enthalten sein. Unter Verwendung der Ladestationskennung der Ladestation 2a kann dieser Verlauf 22a dem Satz 14 zugeordnet werden, was auch für die nachfolgenden Sätze 22b und c gilt.

Fig. 3b zeigt einen Verlauf 22b eines Ladestroms, welcher durch das Fahrzeug 8b beim Laden an der Ladestation 2a entsteht. Auch hier sind wiederum die diskreten Werte 18 als Reihe abgegriffen.

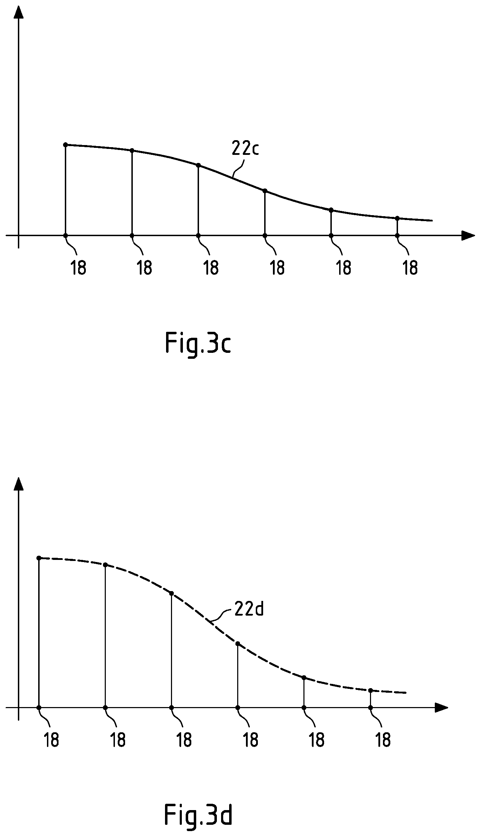

Schließlich zeigt die Fig. 3c einen Verlauf 22c eines Ladevorgangs bei dem das Fahrzeug 8c an der Ladestation 2a lädt.

Die Verläufe der Ladeströme 22a-c sind somit allesamt an der Ladestation 2a erfasst worden und stammen beispielsweise von unterschiedlichen Fahrzeugen 8a-c. Unter Verwendung dieser verschiedenen Verläufe von Ladeströmen 22a-c ist es möglich, den die Ladestation charakterisierenden Verlauf 22d wie in der Fig. 3d gezeigt, zu errechnen. Dieser Verlauf 22d kann beispielsweise durch eine Interpolation der diskreten Werte 18 der Verläufe 22a-c berechnet werden. Auch können Mittelwerte oder dergleichen gebildet werden.

Die Verläufe werden aus der Zeit als Basis und der Ladeleistung als Messpunkte erstellt. Die Charakteristik eines Verlaufs kann durch sein Max/Min Werte und der Zeit dazwischen bestimmt werden. Bei vergleichbaren Rahmenbedingungen (Lademenge, Wetter, Säule, Kabel,...) entstehen vergleichbare Kurven (z.B. Startladeleistung, max. Ladeleistung, Erhaltungsleistung, Ladedauer von Punkt A zu B). Bei Teilladungen finden sich Teilsegmente bzw. wird eine nicht charakteristische Teilladung nicht statistisch berücksichtigt.

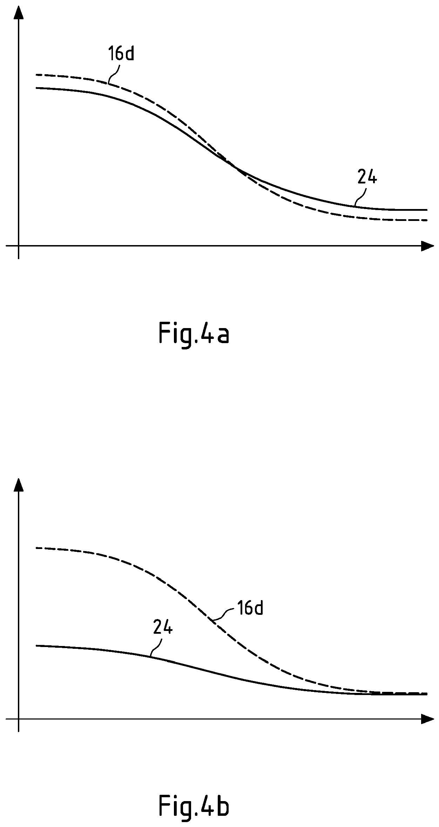

Fig. 4a zeigt beispielhaft den Vergleich eines aktuellen Verlaufs eines Ladestroms 24 mit dem das Fahrzeug charakterisierenden Verlauf des Ladestroms 16d. Der aktuelle Verlauf 24 stammt beispielsweise von dem Fahrzeug 2a an einer der Ladestationen 2a-c. Zu erkennen ist, dass die Abweichung gering ist und in diesem Fall kann davon ausgegangen werden, dass die Ladestation den Ladevorgang korrekt gemessen hat.

Fig. 4b zeigt einen Vergleich eines aktuellen Verlaufs des Ladestroms 24 mit dem das Fahrzeug charakterisierenden Verlauf 16d. Der Verlauf des Ladestroms 24 stammt von einer aktuellen Ladung des Fahrzeugs 8a an einer der Ladestationen 2a-c. Zu erkennen ist eine erhebliche Abweichung zwischen dem das Fahrzeug charakterisierenden Verlauf 16d und dem aktuellen Verlauf 24. Diese Abweichung kann die Ausgabe eines Signals bewirken.

Es wird vorgeschlagen, dass eine Ladekurve als Vektorbild abgebildet wird. Hierbei können die Max/Min Werte und ihr linearer zeitlicher Bezug als Vektor abgespeichert werden. Ein vergleichbarer 30 min Ladevorgang hat bei gleichen Rahmenbedingungen vergleichbare Min/Max Werte und zeitliche Abstände.

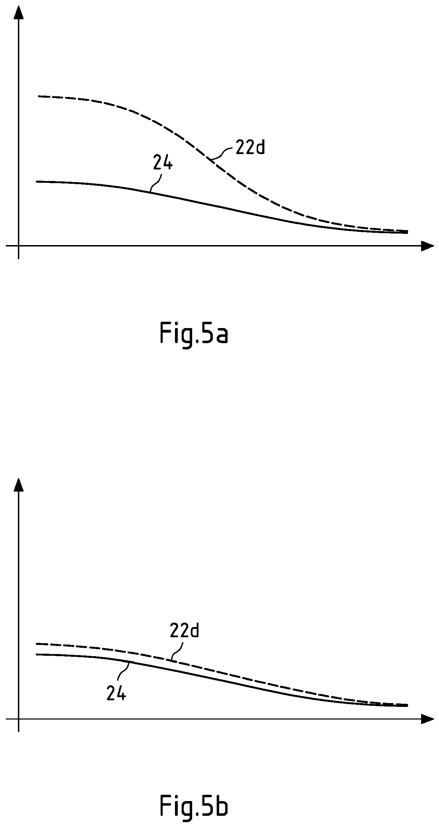

Fig. 5a zeigt den Vergleich des Verlaufs des Ladestroms 24 der Fig. 4b mit dem die Ladestation charakterisierenden Verlauf des Ladestroms 22d. Zu erkennen ist, dass die beiden Verläufe 22d, 24 erheblich voneinander abweichen. Das bedeutet, dass das Fahrzeug 8a an der Ladestation 2a eine im Vergleich zum vorherigen Ladevorgang abweichende Ladekurve aufweist. Dies kann darauf hinweisen, dass nicht die Ladestation 2a defekt ist, sondern das Fahrzeug 8a.

Fig. 5b zeigt ein Vergleich der Kurve 24 mit der Kurve 22. Hier ist zu erkennen, dass die beiden Kurven nahezu identisch sind.

Wurde zuvor, gemäß der Fig. 4b erkannt, dass die Ladekurve des Fahrzeugs 8a gegenüber der das Fahrzeug charakterisierenden Kurve 16d abweicht und wird anschließend festgestellt, dass diese Abweichung nicht in dem Fahrzeug begründet ist, da die Kurve 24 der Kurve 22d nahezu gleich ist, kann darauf geschlossen werden, dass die aktuelle Ladestation defekt ist.

### Bezugszeichenliste

- 2a-c: Ladestation
- 4: Weitverkehrsnetz
- 6: Backend
- 8a-c: Fahrzeug
- 10-14: Satz
- 16a-c: Verlauf des Ladestroms
- 16d: Fahrzeug charakterisierender Verlauf des Ladestroms
- 18: diskrete Werte
- 20: Grenzwert
- 22a-c: Verlauf des Ladestroms
- 22d: Ladestation charakterisierender Verlauf des Ladestroms
- 24: aktueller Verlauf des Ladestroms

## Patentansprüche

1. Verfahren zum Erfassen von Verläufen von Ladeströmen (16a-c) für Elektrofahrzeuge (8a-c) an Ladestationen (2a-c) umfassend:
- Erfassen eines Verlaufs eines Ladestroms (24) an einer Ladestation (2a-c),
- Speicher des Verlaufs des Ladestroms (24) zusammen mit einer Fahrzeugkennung des ladenden Fahrzeugs (8a-c),
**dadurch gekennzeichnet,**
- **dass** für jeweils eine Fahrzeugkennung ein Verlauf des Ladestroms (16a-c) an einer Mehrzahl an Ladestationen (2a-c) gespeichert wird,
- **dass** für jeweils eine Fahrzeugkennung aus den gespeicherten Verläufen von Ladeströmen (16a-c) an verschiedenen Ladestationen (2a-c) ein das Fahrzeug (8a-c) charakterisierender Verlauf des Ladestroms (16d) errechnet wird wobei der das Fahrzeug (8a-c) charakterisierende Verlauf des Ladestroms (16d) als gemittelter Wert der gespeicherten Verläufen von Ladeströmen (16a-c) für die Fahrzeugkennung errechnet wird,und
- **dass** für die jeweilige Fahrzeugkennung ein aktueller Verlauf des Ladestroms (24) mit dem das Fahrzeug (8a-c) charakterisierenden Verlauf des Ladestroms (16d)verglichen wird und bei einer Abweichung des aktuellen Verlaufs des Ladestroms (24) von dem das Fahrzeug (8a-c) charakterisierenden Verlauf des Ladestroms (16d) die größer ist, als ein Grenzwert (20), ein Signal ausgegeben wird.

2. Verfahren nach Anspruch 1,
**dadurch gekennzeichnet.,**
- **dass** für eine Mehrzahl an Ladestationen (2a-c) jeweils Verläufe von Ladeströmen (16a-c) zusammen mit einer Fahrzeugkennung des ladenden Fahrzeugs (8a-c) gespeichert werden.

3. Verfahren nach Anspruch 1 oder 2,
**dadurch gekennzeichnet.,**
- **dass** für jeweils eine von einer Mehrzahl an Ladestationen (2a-c) Verläufe des Ladestroms (16a-c) für eine Mehrzahl von Fahrzeugkennungen gespeichert werden.

4. Verfahren nach Anspruch 3,
**dadurch gekennzeichnet,**
- **dass** ein aktueller Verlauf des Ladestroms (24) mit gespeicherten Verläufe von Ladeströmen (16a-c) an der jeweiligen Ladestation (2a-c) mit verschiedenen Fahrzeugkennungen verglichen wird.

5. Verfahren nach einem der vorangehenden Ansprüche,
**dadurch gekennzeichnet,**
- **dass** für jeweils eine Ladestation (2a-c) aus den gespeicherten Verläufen von Ladeströmen (16a-c) mit verschiedenen Fahrzeugkennungen ein die Ladestation (2a-c) charakterisierender Verlauf des Ladestroms (22d) errechnet wird.

6. Verfahren nach Anspruch 5,
**dadurch gekennzeichnet,**
- **dass** der die Ladestation (2a-c) charakterisierende Verlauf des Ladestroms (22d) als gemittelter Wert der gespeicherten Verläufe von Ladeströmen (16a-c) für die Ladestation (2a-c) errechnet wird.

7. Verfahren nach Anspruch 5 oder 6,
**dadurch gekennzeichnet.,**
- **dass** für jeweils eine Ladestation (2a-c) die Verläufe von Ladeströmen (16a-c) mit verschiedenen Fahrzeugkennungen mit einem aktuellen Verlauf eines Ladestroms (24) für eine Fahrzeugkennung abhängig von dem Signal, verglichen wird.

8. Verfahren nach einem der vorangehenden Ansprüche,
**dadurch gekennzeichnet.,**
- **dass** zusammen mit dem Verlauf des Ladestroms (16a-c) für jeweils eine Fahrzeugkennung eine Temperatur gespeichert wird und dass Verläufe von Ladeströmen (16a-c) in jeweils einem Temperaturbereich einander zugeordnet werden und/oder
- **dass** zusammen mit dem Verlauf des Ladestroms (16a-c) für jeweils eine Fahrzeugkennung eine Information zu einer Kabelgarnitur gespeichert wird und dass Verläufe von Ladeströmen (16a-c) mit jeweils entsprechender Kabelgarnitur einander zugeordnet werden.

## Claims

1. A method for capturing charging current curves (16a-c) for electric vehicles (8a-c) at charging stations (2a-c) comprising:
- capturing of a charging current curve (24) at a charging station (2a-c),
- storing of the charging current curve (24) together with a vehicle identification of the charging vehicle (8a-c),
**characterized in that**
- for each vehicle identification a charging current curve (16a-c) at a plurality of charging stations (2a-c) is stored,
- a charging current curve (16d) characterizing the vehicle (8a-c) is calculated for each respective vehicle (8a-c) identification from the stored charging current curves at different charging stations (2a-c), wherein
- the charging current curve (16d) characterizing the vehicle (8a-c) is calculated as an average value of the stored charging current curves (16a-c) for the vehicle identification, and
- for the respective vehicle identification, a present charging current curve is compared with charging current curve characterizing the vehicle (8a-c) and in case of a derivation of the present charging current curve from the charging current curve characterizing the vehicle (8a-c) which is greater than a threshold, a signal is output.

2. Method according to claim 1,
**characterized in that**
- for a plurality of charging stations (2a-c), respective charging current curves are stored together with a vehicle identification of the charging vehicle (8a-c).

3. Method according to claim 1 or 2,
**characterized in that**
- charging current curves (16a-c) for a plurality of vehicle identifications are respectively stored for a plurality of charging stations (2a-c).

4. Method according to claim 3,
**characterized in that**
- a present charging current curve (24) is compared with stored charging current curves (16a-c) at the respective charging station with different vehicle identifications.

5. Method according to one of the preceding claims,
**characterized in that**
- a charging current curve (22d) characterizing the respective charging station (2a-c) is calculated for each respective charging station (2a-c) from the stored charging currents curves (16a-c) with different vehicle identifications.

6. Method according to claim 5,
**characterized in that**
- the charging current curve (22d) characterizing the charging station (2a-c) is calculated as an average value of the stored charging currents curves (16a.c) for the charging station (2a-c).

7. Method according to claim 5 or 6,
**characterized in that**
- for a respective charging station (2a-c), the charging current curves (16a-c) with different vehicle identifications are compared with a present curve of a charging current (24) for a vehicle identification depending on the signal.

8. Method according to one of the preceding claims,
**characterized in that**
- a temperature is stored together with the charging current curve (16a-c), for a respective vehicle identification and charging current curves (16a-c) in a temperature range are associated with one another, and/or
- information about a cable set is stored together with the charging current curve (16a-c), for a respective vehicle identification, and charging currents curves (16a-c) with corresponding cable sets are associated with one another.

## Revendications

1. Procédé pour détecter des évolutions de courant de charge (16a-c) pour des véhicules électriques (8a-c) à des stations de charge (2a-c) comprenant :
- détection d'une évolution d'un courant de charge (24) à une station de charge (2a-c),
- stockage de l'évolution du courant de charge (24) ensemble avec une identification du véhicule en charge (8a-c),
**caractérisé**
- **en ce que**, pour chaque identification de véhicule, une évolution du courant de charge (16a-c) à une pluralité de stations de charge (2a-c) est mémorisée,
- **en ce que**, pour chaque identification de véhicule, une évolution du courant de charge (16d) caractérisant le véhicule (8a-c) est calculée à partir des évolutions mémorisées de courants de charge (16a-c) à différentes stations de charge (2a-c), l'évolution du courant de charge (16d) caractérisant le véhicule (8a-c) étant calculée comme valeur moyenne des évolutions mémorisées de courants de charge (16a-c) pour l'identification de véhicule, et
- **en ce que**, pour l'identification de véhicule respective, une évolution actuelle du courant de charge (24) est comparée à l'évolution du courant de charge (16d) caractérisant le véhicule (8a-c) et, en cas d'écart entre la évolution actuelle du courant de charge (24) et l'évolution du courant de charge (16d) caractérisant le véhicule (8a-c) qui est supérieur à une valeur limite (20), un signal est émis.

2. Procédé selon la revendication 1,
**caractérisé**
- **en ce que**, pour une pluralité de stations de charge (2a-c), des évolutions de courants de charge (16a-c) sont respectivement mémorisées ensemble avec une identification du véhicule en charge (8a-c).

3. Procédé selon la revendication 1 ou 2,
**caractérisé**
- **en ce que**, pour chacune des stations de charge d'une pluralité de stations de charge (2a-c), des évolutions du courant de charge (16a-c) sont mémorisées pour une pluralité d'identifications de véhicules.

4. Procédé selon la revendication 3,
**caractérisé**
- **en ce qu'**une évolution actuelle du courant de charge (24) est comparée à des évolutions mémorisées de courants de charge (16a-c) à la station de charge respective (2a-c) avec différentes identifications de véhicule.

5. Procédé selon l'une des revendications précédentes,
**caractérisé**
- **en ce que**, pour chaque station de charge (2a-c), une évolution du courant de charge (22d) caractérisant la station de charge (2a-c) est calculée à partir des évolutions mémorisées de courants de charge (16a-c) avec différents identifications de véhicule.

6. Procédé selon la revendication 5,
**caractérisé**
- **en ce que** l'évolution du courant de charge (22d) caractérisant la station de charge (2a-c) est calculée comme valeur moyenne des évolutions mémorisées des courants de charge (16a-c) pour la station de charge (2a-c).

7. Procédé selon la revendication 5 ou 6,
**caractérisé**
- **en ce que**, pour chaque station de charge (2a-c), les évolutions de courants de charge (16a-c) avec différentes identifications de véhicule sont comparées à une évolution actuelle d'un courant de charge (24) pour une identification de véhicule en fonction du signal.

8. Procédé selon l'une des revendications précédentes,
**caractérisé**
- **en ce qu'**une température est mémorisée ensemble avec l'évolution du courant de charge (16a-c) pour chaque identification de véhicule, et en ce que des évolutions de courants de charge (16a-c) sont associées les unes aux autres dans une plage de températures respective,
et/ou
- **en ce qu'**une information concernant une garniture de câble est mémorisée ensemble avec l'évolution du courant de charge (16a-c) pour chaque identification de véhicule, et en ce que des évolutions de courants de charge (16a-c) avec une garniture de câble correspondante sont associées les unes aux autres.
